# EUROPEAN PATENT SPECIFICATION

(11) **EP 1 354 095 B1**
(45) Date of publication and mention of the grant of the patent: **23.03.2011**
(21) Application number: 01994342.2
(22) Date of filing: 27.12.2001
(51) Int. Cl.: D21H 13/26, B32B 27/04, H05K 1/03

(54) **NON-WOVEN SHEET OF ARAMID FLOC**
VLIES AUS ARAMIDFLOCKEN
FEUILLE NON TISSEE DE FLOC ARAMIDE

(30) Priority: 23.01.2001 US 767584
(43) Date of publication of application: 22.10.2003
(73) Proprietor: E.I. DU PONT DE NEMOURS AND COMPANY, Wilmington, DE 19898 (US)
(72) Inventor: LEVIT, Mikhail, R., Richmond, VA 23229 (US)
(74) Representative: Beacham, Annabel Rose
(86) International application number: PCT/US2001/049574
(87) International publication number: WO 2002/059411

(56) References cited:
- US-A- 4 524 103
- US-A- 4 729 921
- US-A- 4 902 564
- US-A- 5 223 094
- US-A- 5 314 742

## Description

### BACKGROUND OF THE INVENTION

### 1. Field of the Invention

This invention relates to a non-woven sheet that includes aramid floc. Such sheets may be impregnated with a resin and used as a substrate for a printed wiring board or other composite structures.

### 2. Description of the Related Art

It is known in the art to use non-woven aramid sheets as substrates for printed wiring boards or other composite structures. These sheets are usually impregnated with a resin and made into laminates that have a low coefficient of thermal expansion and that are used in printed wiring boards.

Non-woven aramid sheets can be produced by wet papermaking technology by using various binders with the aramid fibers. US Patent 5,314,742 discloses a non-woven aramid sheet that is prepared from 75 to 95 weight percent para-aramid floc and from 5 to 25 weight percent poly(m-phenylene isophthalamide) fibrids. US Patent 5,223,094 discloses a non-woven aramid sheet made from 45 to 97 weight percent poly(p-phenylene terephthalamide) floc, from 3 to 30 weight percent poly(m-phenylene isophthalamide) fibrids, and from 0 to 35 weight percent of quartz fiber. In both of these patents, the disclosed fibrids act as a binder during the paper-forming process.

US Patent 4,698,267 discloses high density para-aramid papers that contain short para-aramid fibers selected from the group consisting of para-aramid pulp, para-aramid floc and mixtures thereof. The paper contains from 5 to 25 weight percent of a binder of water dispersible polymeric materials or aramid fibrids. This patent teaches that the binder may be omitted when batch methods of paper preparation are used. However, while not identified as such, the para-aramid pulp acts as a binder in these papers.

The binder in the non-woven sheets described in the above prior art references is an impurity that acts mostly as a defect in the sheet when that sheet is impregnated and used as a substrate. The negative impact of a binder used in the papermaking process on a composite structure depends on the type and quantity of binder used, but in general the problems caused by such a binder include low physical and mechanical properties compared to aramid floc, higher moisture absorption, and poorer thermal properties. Further, such a binder can interfere with the interaction between aramid floc and a primary binder, such as an epoxy, polyimide or other resin, used in a laminate in a composite structure, which decreases the physical and mechanical properties of that composite structure.

In the manufacture of a non-woven sheet, it is known to hydroentangle a sheet made by a wet-lay forming process. However, the hydroentangling is used only with low modulus fibers. For example, US Pat. 4,902,564 describes a method for producing highly absorbent non-woven by wet-lay forming followed by hydroentangling wherein the non-woven consists of polypropylene, nylon, or polyester fibers, and wood pulp as a binder.

Heretofore, non-woven sheets made from aramid fibers that have been hydroentangled have been made only by dry-laid processes. Further, these sheets have had significant directionality, meaning significant differences in strength in the machine and cross directions of the sheet.

The problems in the prior art are overcome by the present invention because the sheet in the wet-lay or papermaking process is essentially free of binders used in the papermaking process. Also, the wet-laid non-woven sheet, and products made using that non-woven sheet, are free from the negative effects of having a binder present in the non-woven sheet. The inventive sheet may be hydroentangled and calendered to improve the physical properties of the sheet.

### SUMMARY OF THE INVENTION

The present invention relates to a wet-laid non-woven sheet of aramid floc and less than 2 weight percent binder based upon the total weight of the binder and floc, wherein the aramid floc includes at least 25 percent by weight of para-aramid floc based on the total weight of aramid floc only.

The invention also relates to a process for making a sheet of aramid floc, wherein the aramid floc includes at least 25 percent by weight of para-aramid floc based on the total weight of aramid floc only, and wherein the sheet comprises less than 2 weight percent binder based upon the total weight of the binder and floc, by a) preparing an aqueous dispersion of 0.005 to 0.08 weight percent of aramid floc that includes at least 25 percent by weight of para-aramid floc based on the weight of the floc only, and less than 2 weight percent binder based upon total weight of the binder and floc; b) pouring the dispersion onto a moving screen in a paper making machine; c) withdrawing water from the aqueous dispersion to leave a wet non-woven felt; and d) drying the wet non-woven felt on the supportive screen to make a sheet of essentially binder-free and pulp-free aramid floc. The sheet may be hydroentangled before or after being dried. Further, the sheet may be hot-calendered to increase its strength, whether or not that sheet has been hydroentangled

### DETAILED DESCRIPTION

The present invention provides an improved wet-laid non-woven sheet that is useful, for example, as a substrate for printed circuit boards. The non-woven sheet is made from aramid floc and is essentially free of binders such as pulp, fibrids or water dispersible polymeric materials. The non-woven sheet is made in a wet-laid non-woven process Optionally, the non-woven sheet may be hydroentangled before or after being dried. Further, the non-woven sheet may be hot-calendered. The sheet may be impregnated with a resin and may be formed into a laminate for use in a final composite structure such as a printed circuit wiring board.

It is surprising and unexpected that essentially binder-free para-aramid floc, without being refined or subjected to other treatment, can be used to make a wet-laid sheet having sufficient strength to be processed on a paper-making machine and to be wound up in a roll. Also, it surprising and unexpected that a non-woven structure, such as a sheet, made from relatively short para-aramid floc (3-13 mm) can be successfully hydroentangled. A further discovery is that an essentially binder-free aramid sheet can be dramatically strengthened by a hot calendering process.

A non-woven sheet of the invention exhibits a better uniformity than a similar sheet made using binders in the papermaking process. Further, such a sheet delivers essentially pure aramid floc to the impregnation step of the process for preparing a final composite structure that includes the impregnated non-woven sheet.

The term "floc", as used herein, means fibers that are cut to a short length that is customarily used in the preparation of wet-laid sheets. Such floc has a specific surface area of less than one square meter per gram. Aramid floc is made by cutting continuous aramid fibers, such as those prepared by processes described in U.S. Patent Nos. 3,063,966, 3,133,138, 3,767,756, and 3,869,430.

The term "aramid fiber", as used herein, means aromatic polyamide fiber, wherein at least 85% of the amide (-CONH-) linkages are attached directly to two aromatic rings. Additives can be used with the aramid, and it has been found that up to as much as 10 percent by weight of other polymeric material can be blended with the aramid or that copolymers can be used having as much as 10 percent of other diamine substituted for the diamine of the aramid or as much as 10 percent of other diacid chloride substituted for the diacid chloride of the aramid. Para-aramid polymers are the primary polymers in fibers used to make the floc of this invention and poly(p-phenylene terephthalamide)(PPD-T) is the preferred para-aramid. Meta-aramid fibers may also be used in the floc of this invention and poly(m-phenylene isophthalamide)(MPD-I) is the preferred meta-aramid.

The term "fibrids", as used herein, means very small, nongranular, fibrous or film-like particles with at least one of their three dimensions being of minor magnitude relative to the largest dimension. These particles are prepared by precipitation of a solution of polymeric material using a non-solvent under high shear. The term "aramid fibrids", as used herein, means non-granular film-like particles of aromatic polyamide having a melting point or decomposition point above 320C. The fibrids have an average length of 0.2 to 1 mm with a length-to-width aspect ratio of 5:1 to 10:1. The thickness dimension is on the order of a fraction of a micron. Such aramid fibrids, before being dried, can be used wet and can be deposited as a binder physically entwined about the aramid floc component of a paper.

The term "pulp", as used herein, means cellulose fibers or fibrillated made-made fibers, which are refined or subjected to some other special treatment to be fibrillated. The term "aramid pulp" means aramid material having many fibrils, mostly attached to fiber "trunks" but also unattached. The trunk is generally columnar and about 10 to 50 microns in diameter and the fibrils are hair-like members only a fraction of a micron or a few microns in diameter attached to the trunk and about 10 to 100 microns long.

The term "essentially binder-free", as used herein, means that any binder from a papermaking process present in the non-woven sheet is present in an amount less than 2 weight percent, preferably less than 1 weight percent, and most preferably 0 weight percent. These percentages are based upon the total weight of binder from a papermaking process and floc only. The term "binder from a paper-making process", as used herein, means fibrids, pulp, adhesives or polymeric materials that are typically used to bind fibers together in a paper-making process. In the making of paper or sheets from para-aramid floc, it has long been the practice to include binders to assure that the paper fibers adhere together to yield a sheet of acceptable strength and integrity. As an alternative, the para-aramid papers have been made using pulp instead of floc. Para-aramid pulp is refined and has many fibrils which are believed to act as hooks or fasteners to hold together adjacent particles in the paper and provide integrity to the finished paper sheet. Pulp typically has a specific surface area of from 5 to 15 square meters per gram. With the invention, there is no need to use a binder in the wet-lay process and is preferred to not use a binder for the reasons mentioned above. However, while the resultant product is not as good, very small amounts of binder may be used within the weight ranges above to make the non-woven sheet of the invention.

Polymeric dispersants or processing aids or other polymeric additives which could be used in the wet-lay process to improve sheet uniformity, reduce the use of water, or any other purpose, even though such materials may have some binding effect, their primary purpose is not as a binder and therefore these materials are not included in the meaning of the term "binders from a papermaking process".

Wet-lay non-woven sheets and papers made from aramid floc were not, until now, made using essentially binder-free aramid floc because there was a belief that a floc-only sheet would not hold together and would lack strength and integrity. Surprisingly, it has been found that there is enough cohesiveness in the para-aramid floc in wet and dry sheets to make acceptable non-woven sheets. Therefore, it is possible to produce a continuous wet-lay non-woven sheet from essentially binder-free aramid floc only using known sheet-forming apparatuses and supporting screens in the drying section of a papermaking machine.

A further surprising result of the invention is that an aramid non-woven sheet made from para-aramid floc, which is inherently relatively short, can be successfully hydroentangled. A third surprising result is a dramatic increase of the strength of a wet-laid non-woven sheet made from essentially binder-free para-aramid when that sheet has been subjected to a hot calendering process, whether or not that sheet has been hydroentangled. Until now, there was a belief that it is necessary to have a binder present in the sheet in order to increase the strength of a wet-laid non-woven sheet made from para-aramid because it was believed that the binder, when subjected to the hot calendering process, exhibited a reversible transition from a solid to a soft stage and back to a solid that fixed the densified structure and increased the strength of the sheet.

The present invention is directed to a essentially binder-free wet-laid non-woven sheet comprising aramid floc, wherein the aramid floc includes at least 25 percent by weight of para-aramid floc based on the total weight of aramid floc only. Preferably the aramid floc contains at least 50 percent by weight, and more preferably at least 75 percent by weight, and most preferably 100 percent by weight, of para-aramid floc. If less than 25 percent by weight of para-aramid floc is used, the resulting sheet will not have sufficient strength to be processed on a papermaking machine.

The remaining aramid floc is preferably meta-aramid floc. However, depending on the final application of the non-woven sheet, other floc can be used in combination with the para-aramid floc. For example, polypropylene, polyester or another thermoplastic floc can be added to the para-aramid floc of the invention to produce, for example, shaped forms from the sheet in a molding process. If the floc includes one or more different flocs in addition to para-aramid floc, the additional flocs are blended with the para-aramid floc preferably in an aqueous dispersion.

The aramid floc used in the invention has an average length of from 3 to 13 millimeters, preferably from 5 to 8 millimeters. The para-aramid floc is straight floc obtained by cutting aramid fiber or yarn without any further refining or other fibrillating treatment of the floc. Crimped aramid floc may be blended with the straight floc and used to make the non-woven sheets of the invention. It is preferred that the aramid floc include at least 25 weight percent of straight floc based on the total weight of straight floc and crimped floc only.

There is no limitation on the tex or on the cross-sectional shape of the fiber used in the floc of this invention.

The wet-laid sheet of the invention may be made by any known process for wet-lay forming a non-woven sheet. However, if the non-woven sheet to be dried is not hydroentangled before the sheet is dried, then a supporting screen is necessary in the drying stage of the process. An example of such a process for making the sheet of the invention includes the steps of:
a) preparing an aqueous dispersion of 0.005 to 0.08 weight percent of essentially binder-free aramid floc that includes at least 25 percent by weight of para-aramid floc;
b) pouring the dispersion onto a moving screen in a paper making machine;
c) withdrawing water from the aqueous dispersion to leave a wet non-woven felt; and
d) drying the wet paper felt on a supporting screen to make a sheet of essentially binder-free aramid floc.

Optionally, the non-woven sheet may be hydroentangled before or after being dried. Hydroentangling results in a wet-laid non-woven sheet of aramid floc that exhibits an increase in density and strength compared to a wet-laid non-woven sheet that has not been hydroentangled. The hydroentangling may be performed by conventional processes, such as is disclosed in US Patent No. 4,902,564, the text of which is hereby incorporated by reference.

As a further option, the wet-laid non-woven sheet may be hot calendered, which leads to an unexpected and significant increase in the strength of the non-woven sheet of aramid floc. The calendering temperature can be from 100 to 400C, preferably from 240 to 380C. It is preferred that the sheet to be hot calendered is hydroentangled, but this is not a requirement.

The wet-laid non-woven sheet can be impregnated with resins, such as epoxy, polyimide, phenolic, silicone, or other, or combinations thereof, using conventional processes to make a prepreg. The prepreg can then be made into a laminate using conventional processes. These laminates can be made into wiring boards or other composite structures.

The aramid non-woven sheets of the invention, in addition to aramid floc and less than 3 weight percent of a binder from a papermaking process, can include 15 to 85 weight percent filler and 0 to 30 weight percent other components. The fillers can be inorganic materials such as diatomaceous earth, talc, carbon, and the like. The other components can include other fibers, such as glass fibers, or ceramic fibers, and the like.

Non-woven sheets of essentially binder-free para-aramid floc can be made by a wet-lay manufacturing process that is simpler compared to processes for wet-lay manufacturing of non-woven sheets that include a binder from a papermaking process. Further, by incorporating an essentially-binder free non-woven sheet, a final composite structure that includes a resin-impregnated sheet of the invention has better physical and mechanical properties at the same testing conditions compared to a composite structure having a non-woven sheet that includes a binder from the papermaking process, because that binder is mostly an impurity that can cause defects in the final composite structure.

In addition to their use in printed wiring boards, non-woven sheets of this invention can be used in the manufacture of composite structures such as multi-chip modules and electronic interconnect devices. Also, the inventive sheets can be used in the aircraft industry and other end uses of composites that include para-aramid fibers.

### TEST METHODS

The following test methods were used in the Examples below. The tensile strength of the wet-laid non-woven sheets was measured on an Instron-type testing machine using test specimens 2.54 cm wide and a gage length of 18 cm, in accordance with ASTM D 828.

The thickness and basis weight of the non-woven sheets were determined by measuring the thickness and the weight of an area of a sample of the test non-woven sheet in accordance with ASTM D 645 and D646, respectively.

The peel strength of copper clad laminates was determined in accordance with IPC-TM-650, Number 2.4.8.

The coefficient of thermal expansion (CTE) in the z-axis of the laminates was determined by thermal mechanical analysis (TMA) performed in accordance with IPC-TM-650, number 2.4.24.

The CTE in-plane of the laminates was determined by TMA in accordance with IPC-TM-650, number 2.4.41.

The water absorption of the laminates was determined in accordance with IPC-TM-650, Number 2.6.2.1.

### EXAMPLES

### Examples 1-6

Aqueous dispersions of para-aramid floc of varying length and diameter were made, and wet-laid non-woven sheets were prepared from those dispersions by wet-forming the dispersion on a Rotonier machine (a combination of cylinder paper making machine and the Fourdrinier) equipped with a horizontal through-air dryer with a supportive metal screen (Kitchen & Perry Flat-Bed Thru Dryer). The floc was from poly (para-phenylene terephthalamide) fiber sold by E.I. du Pont de Nemours and Company under the trademark KEVLAR^{®} 49. No binders were added to the floc.

The tensile strength and elongation in both the machine direction and the cross direction of the non-woven sheets made from this para-aramid floc were measured and are shown in Table 1. These data demonstrate that while all of the essentially binder-free aramid floc resulted in a usable non-woven sheet, a length of para-aramid floc of about 6-7 mm provided a better wet-laid non-woven sheet compared with a floc of 3 mm or a floc of about 13 mm. Note that in Examples 5 and 6 a non-woven sheet of the invention was made, but not in a continuous sheet, and therefore it was not possible to perform tensile strength or elongation tests on those sheets.

**Table 1**

| Ex. No. | Para-aramid floc used | Basis wt. | Thickness | Tensile | | Elongation | |
|---|---|---|---|---|---|---|---|
| | | | | strength | | % | |
| | | | mm | N/m | | MD | CD |
| | | g/m2 | | MD | CD | | |
| 1 | KEVLAR^{®}49 0.16 tex, 6.7 mm | 113 | 1.0 | 115 | 76 | 1.2 | 1.7 |
| 2 | KEVLAR^{®}49 0.16 tex, 6.7 mm | 190 | 1.7 | 140 | 92 | 2.0 | 3.0 |
| 3 | KEVLAR^{®} 49 0.25 tex, 6.7 mm | 127 | 1.2 | 67 | 45 | 2.2 | 3.3 |
| 4 | KEVLAR^{®}49 0.25 tex, 6.7 mm | 201 | 1.9 | 86 | 65 | 2.0 | 2.1 |
| 5 | KEVLAR^{®}9 0.25 tex, 3.3 mm | 195 | 1.9 | * | | * | |
| 6 | KEVLAR^{®}49 0.25 tex, 13 mm | 207 | 2.0 | * | | * | |

| | | | | | | | |
|---|---|---|---|---|---|---|---|
| * Sheets made were not continuous and standard tensile and elongation tests could not be conducted. | | | | | | | |

### Examples 7-9 and Comparative Example 10

Aqueous dispersions were made as in Examples 1-6 except that the dispersions included both meta-aramid floc and para-aramid floc at different weight ratios. These aqueous dispersions were made into wet-laid non-woven sheets as in Examples 1-6.

The meta-aramid floc was poly (metaphenylene isophthalamide) floc of a linear density of 0.22 tex and a length of 0.64 cm and is sold by E.I. du Pont de Nemours and Company under trade name NOMEX^{®}.

The para-aramid floc was made using poly (para-phenylene terephthalamide) fiber sold by E.I. du Pont de Nemours and Company under the trademark KEVLAR^{®} 49, and had a linear density of 0.16 tex and a length of 6.7 mm. No binders were added to the floc.

The tensile strength and elongation in both the machine direction and the cross direction of the non-woven sheets were measured and are shown in Table 2. These data show that if para-aramid floc and meta-aramid floc are blended together and used to make an essentially binder-free non-woven sheet of the invention, it is necessary to have at least 25% of para-aramid floc in such a blend to permit the continuous production of a wet-laid non-woven sheet. Note that in Example 9 a non-woven sheet of the invention was made but not in a continuous sheet and therefore it was not possible to perform tensile strength or elongation tests on that sheet.

**Table 2**

| Ex. No. | Wt.% of meta-aramid floc in blend with para-aramid floc | Basis wt. | Thickness | Tensile strength N/m | | Elongation % | |
|---|---|---|---|---|---|---|---|
| | | g/m2 | mm | MD | CD | MD | CD |
| 7 | 25 | 205 | 1.9 | 110 | 72 | 1.8 | 2.6 |
| 8 | 50 | 190 | 1.7 | 57 | 44 | 2.8 | 3.2 |
| 9 | 75 | 197 | 1.6 | * | * | * | * |
| C10 | 100 | 201 | ** | ** | ** | ** | ** |

| | | | | | | | |
|---|---|---|---|---|---|---|---|
| * Sheet made was not continuous and so standard tensile and elongation tests could not be conducted. ** Sheet made was too weak to be transited from the forming wire to the drying section | | | | | | | |

### Example 11

A wet-laid non-woven sheet was made as described in Examples 1-6, and had a basis weight of 374 g/m². The non-woven sheet was impregnated between two polyester screens with water-based phenolic resin diluted to 15% of solids and then was dried at 120 C to form a prepreg. The phenolic resin used was Durez 33-304 sold by OxyChem Co.

The floc used was the same as in Examples 7-10. No binders were added to the floc.

The prepreg produced contained 30.3 wt.% of phenolic resin and had a density of 0.1 g/cm³ and a tensile strength of 14.7 and 7.3 kN/m in the machine and cross directions respectively. These data show that an acceptable prepreg can be prepared from a wet-laid aramid non-woven sheet of this invention immediately after forming the sheet, without any hydroentangling or calendering of the wet-laid sheet.

### Examples 12-13

A wet-laid non-woven sheet was made as described in Examples 1-6 except that the dried formed sheet was hydroentangled, with preliminary wetting, on a pilot washing machine.

A metal screen of 100 mesh was used as a carrier belt on the washing machine. The hydroentangling process was conducted at a speed of 23 m/min.

The para-aramid floc used was the same as in Examples 7-10. No binders were added to the floc.

The sheet in Example 12 was hydroentangled by consecutive treatment from both sides. One side was treated with water jets from two manifolds, which had a 0.18 mm orifice diameter at 8 orifices per cm, at a pressure of 2.1 and 3.4 MPa respectively, and from three manifolds, which had a 0.13 mm orifice diameter at 16 orifices per cm, and at a pressure of 5.5 MPa. Another side was treated with water jets from two manifolds, which had a 0.18 mm orifice diameter at 8 orifices per cm, and at a pressure of 2.1 and 3.4 MPa respectively, from three manifolds, which had a 0.13 mm orifice diameter at 16 orifices per cm, at a pressure of 5.5 MPa, and from one manifold, which had a 0.10 mm orifice diameter at 32 orifices per cm, and at a pressure of 5.5 MPa.

The sheet in Example 13 was hydroentangled by treatment only from one side. The treatment was conducted consecutively with water jets from two manifolds, which had a 0.18 mm orifice diameter at 8 orifices per cm, at a pressure of 2.1 and 3.4 MPa respectively, and from three manifolds, which had a 0.13 mm orifice diameter at 16 orifices per cm, and at a pressure of 5.5 MPa.

Properties of hydroentangled materials are shown in Table 3. These data show that hydroentangling of a wet-laid aramid non-woven sheet from essentially
binder-free aramid floc provides densification and additional strengthening of the sheet compared to a sheet that is not hydroentangled, such as the sheets in Examples 1-6.

**Table 3**

| | Basis wt. | Thickness | Tensile strength N/m | | % Elongation | |
|---|---|---|---|---|---|---|
| | g/m² | (mm) | MD | CD | MD | CD |
| Example 12 | 92 | 0.64 | 130 | 89 | 1.7 | 2.6 |
| Example 13 | 94 | 0.81 | 109 | 78 | 1.5 | 2.3 |
| Example 14 | 67 | 0.42 | 66 | 48 | 1.5 | 2.2 |
| Example 15 | 34 | 0.23 | 29 | 21 | 1.4 | 1.9 |
| Example 16 | 33 | 0.20 | 38 | 34 | 1.6 | 2.2 |

### Example 14

An aqueous dispersion was made of para-aramid floc, and a wet-laid non-woven sheet was formed from this dispersion on a Deltaformer inclined wire machine.

The material was collected in wet form after leaving the wire and was hydroentangled on a pilot washing machine as in Examples 12-13.

The para-aramid floc used was the same as in Examples 7-10. No binders were added to the floc.

The non-woven material was hydroentangled by consecutive treatment from both sides. One side was treated with water jets from eight manifolds, which had a 0.13 mm orifice diameter at 16 orifices per cm, and at a pressure of 1.4, 5.5, 8.3, 11.0, 13.8, 13.8, 13.8, and 13.8 MPa respectively. Another side was treated with water jets from four manifolds, which had a 0.13 mm orifice diameter at 16 orifices per cm, and at a pressure of 3.4, 6.9, 10.3, and 13.8 MPa respectively.

The properties of the hydroentangled non-woven sheets are shown in Table 3. These data show that wet-laid aramid non-woven sheets of the invention can be successfully hydroentangled before being dried. Further, when compared with the data in Examples 12-13, these data show that the non-woven sheets of the invention can be hydroentangled before or after being dried and still provide acceptable physical properties.

### Example 15

An aqueous dispersion was made of 100 weight percent para-aramid floc, and a wet-laid non-woven sheet was formed from this dispersion in a handsheet mold and dried on a metal screen of 100 mesh. Afterwards, the sheet was hydroentangled, with preliminary wetting, on a pilot washing machine as in Examples 12-13.

The para-aramid floc used was from poly (para-phenylene terephthalamide) fiber sold by E.I. du Pont de Nemours and Company under the trademark KEVLAR^{®} 149 and had a linear density of 0.16 tex and a length of 6.7 mm. No binders were added to the floc.

The non-woven material was hydroentangled by consecutive treatment from both sides. One side was treated with water jets from four manifolds, which had a 0.13 mm orifice diameter at 16 orifices per cm, at a pressure of 1.4, 3.4, 5.5, and 6.9 MPa respectively. Another side was treated with water jets from four manifolds, which had a 0.13 mm orifice diameter at 16 orifices per cm, and at a pressure of 2.1, 4.8, 6.9, and 8.3 MPa respectively.

The properties of the hydroentangled non-woven sheet are shown in Table 3. These data show that the non-woven sheets of this invention can be hydroentangled successfully using a para-aramid floc and as KEVLAR^{®} 149, which is characterized by a very high modulus and a low moisture regain compared with KEVLAR^{®} 49 or KEVLAR^{®} 29.

### Example 16

A wet-laid non-woven sheet was formed as in Example 15 except that the para-aramid floc used was made from poly (para-phenylene terephthalamide) fiber sold by E.I. du Pont de Nemours and Company under the trademark KEVLAR^{®} 29 and had a linear density of 0.096 tex and a length 6.7 mm.

The non-woven material was hydroentangled by consecutive treatment from both sides. Each side was treated with water jets from four manifolds, which had 0.13 mm orifice diameter at 16 orifices per cm, at a pressure of 0.7, 2.1, 3.4, and 4.8 MPa respectively.

The properties of the final non-woven sheet are shown in Table 3. These data show that a reduction in the diameter of the para-aramid floc can lead to some improvement in the mechanical properties of a hydroentangled sheet made from a wet-laid non-woven of essentially binder-free aramid floc.

### Example 17

Two wet-laid non-woven sheets of different basis weights were formed and hydroentangled as in Example 12. In addition, the sheets were hot calendered at 300C between two metal rolls each having a diameter of 20.3 cm diameter and at a linear pressure of about 2000 N/cm. The properties of the calendered sheets are shown in Table 4. When compared with the data in Table 3, these data show that calendering dramatically increases the strength of an aramid non-woven sheet of this invention. Also, the data indicate that it is possible to produce an aramid non-woven sheet having about the same strength in both the machine and the cross directions of the sheet.

**Table 4**

| Basis weight | Thickness (mm) | Tensile strength (N/m) | | % Elongation | |
|---|---|---|---|---|---|
| (g/m²) | | MD | CD | MD | CD |
| 67.8 | 0.067 | 600 | 360 | 0.53 | 3.0 |
| 90.5 | 0.104 | 1240 | 1240 | 0.19 | 0.49 |

### Example 18

A wet-laid non-woven sheet was formed and hydroentangled as in Example 12 and was calendered as in Example 17. The sheet was impregnated on a vertical prepregging tower using an epoxy resin system with Tg about 165 C. The epoxy resin system used was L - 1070 sold by Fortin Industries, Inc. A 2 ply copper clad laminate was produced using a vacuum press. The final laminate contained 46.7% of the resin.

Properties of the laminate are shown in Table 5 and are compared with published values for a THERMOUNT^{®} laminate based on a DuPont Type E-200 reinforcement from KEVLAR^{®} 49 floc having a binder of meta-aramid (NOMEX^{®}) fibrids. The data show that for the same type of KEVLAR^{®} floc and the same type of resin in the final laminate, the wet-laid non-woven sheet of the invention improves three very important properties for printing wiring boards and similar applications compared to a standard wet-laid non-woven sheet that contains greater than 3 weight percent of a binder from the papermaking process: namely, CTE, cooper peel strength, and moisture absorption.

**Table 5**

| Property | Laminate of Example 18 | Typical value for THERMOUNT^{®} laminate based on DuPont Type E-200 reinforcement with epoxy (48% resin content) |
|---|---|---|
| In-plane CTE (average between MD and CD) | 7.0 ppm/C | 8.2-8.5 ppm/C* |
| Copper peel strength | 11 N/cm | 7-8 N/cm* |
| Moisture absorption | 0.23% | 0.4 - 0.5% |

| | | |
|---|---|---|
| * THERMOUNT^{®} Laminate and Prepreg Containing Type E210, E220, E230 Non-woven Aramid Reinforcement For Printed Wiring Boards, Multichip Modules, and Electronic Interconnect Devices (Product Bulletin, H-52775, Rev. 5, 2/98). | | |

## Claims

1. A wet-laid non-woven sheet of aramid floc and less than 2 weight percent binder based upon the total weight of the binder and floc, wherein the aramid floc includes at least 25 percent by weight of para-aramid floc based on the total weight of aramid floc only.

2. The wet-laid non-woven sheet of claim 1, wherein the aramid floc includes 100 percent by weight of para-aramid floc based on the total weight of aramid floc only.

3. The wet-laid non-woven sheet of claim 1 or claim 2, wherein the aramid floc has an average length of from 3 to 13 millimeters

4. The wet-laid non-woven sheet of claim 1, wherein the aramid floc comprises para-aramid floc and meta-aramid floc.

5. A prepreg that includes the wet-laid non-woven sheet of any of claims 1 to 4.

6. A laminate made from the prepreg of claim 5.

7. A printed wiring board that includes the laminate of claim 6.

8. A process for making a sheet of aramid floc, wherein the aramid floc includes at least 25 percent by weight of para-aramid floc based on the total weight of aramid floc only, and wherein the sheet comprises less than 2 weight percent binder based upon the total weight of the binder and floc, comprising the steps of:
a) preparing an aqueous dispersion of 0.005 to 0.08 weight percent of aramid floc that includes at least 25 percent by weight of para-aramid floc based on the weight of the floc only, and less than 2 weight percent of binder based upon the total weight of the binder and floc;
b) pouring the dispersion onto a moving screen in a paper making machine;
c) withdrawing water from the aqueous dispersion to leave a wet paper felt; and
d) drying the wet paper felt on the supporting screen to make a sheet of essentially binder-free aramid floc.

9. The process of Claim 8 wherein the aramid floc has an average length of from 3 to 13 millimeters.

10. The process of Claim 8 or claim 9 further comprising the step of hydroentangling the non-woven sheet before or after the non-woven sheet is dried.

11. The process of any of claims 8 to 10 further comprising the step of hot calendering the dried sheet of essentially binder-free aramid floc.

## Patentansprüche

1. Nass gelegtes Vlies aus Aramidflocken und weniger als 2 Gewichtsprozent Bindemittel, auf das Gesamtgewicht des Bindemittels und der Flocken bezogen, wobei die Aramidflocken mindestes 25 Gewichtsprozent Para-Aramidflocken, auf das Gesamtgewicht der Aramidflocken als solchen bezogen, umfassen.

2. Nass gelegtes Vlies nach Anspruch 1, wobei die Aramidflocken 100 Gewichtsprozent Para-Aramidflocken, auf das Gesamtgewicht von Aramidflocken als solchen bezogen, umfassen.

3. Nass gelegtes Vlies nach Anspruch 1 oder Anspruch 2, wobei die Aramidflocken eine durchschnittliche Länge von 3 bis 13 Millimetern aufweisen.

4. Nass gelegtes Vlies nach Anspruch 1, wobei die Aramidflocken Para-Aramidflocken und Meta-Aramidflocken umfassen.

5. Prepreg, das das nass gelegte Vlies nach einem der Ansprüche 1 bis 4 umfasst.

6. Laminat, das aus Prepreg nach Anspruch 5 hergestellt ist.

7. Leiterplatte, die das Laminat nach Anspruch 6 umfasst.

8. Verfahren zum Herstellen einer Bahn aus Aramidflocken, wobei die Aramidflocken mindestens 25 Gewichtsprozent Para-Aramidflocken, auf das Gesamtgewicht der Aramidflocken als solchen bezogen, umfassen und wobei die Bahn weniger als 2 Gewichtsprozent Bindemittel, auf das Gesamtgewicht des Bindemittels und der Flocken bezogen, umfasst, das Folgende Schritte umfasst:
a) das Herstellen einer wässrigen Dispersion von 0,005 bis 0,08 Gewichtsprozent Aramidflocken, die mindestens 25 Gewichtsprozent Para-Aramidflocken, auf das Gewicht der Flocken als solchen bezogen, und weniger als 2 Gewichtsprozent Bindemittel, auf das Gesamtgewicht des Bindemittels und der Flocken bezogen, umfasst;
b) das Gießen der Dispersion auf ein sich bewegendes Sieb in einer Papierherstellungsmaschine;
c) das Abziehen von Wasser aus der wässrigen Dispersion, um einen nassen Papierfilz zu hinterlassen; und
d) das Trocknen des nassen Papierfilzes auf dem Trägersieb, um eine Bahn von im Wesentlichen bindemittelfreien Aramidflocken herzustellen.

9. Verfahren nach Anspruch 8, wobei die Aramidflocken eine durchschnittliche Länge von 3 bis 13 Millimetern aufweisen.

10. Verfahren nach Anspruch 8 oder Anspruch 9, des Weiteren den Schritt des Hydroverwirrens des Vlieses bevor oder nachdem das Vlies getrocknet worden ist, umfassend.

11. Verfahren nach einem der Ansprüche 8 bis 10, des Weiteren den Schritt des Heißkalandrierens der getrockneten Bahn von im Wesentlichen bindemittelfreien Aramidflocken umfassend.

## Revendications

1. Feuille non tissée par voie humide de floc d'aramide et moins de 2 pour cent en poids de liant par rapport au poids total du liant et du floc, dans laquelle le floc d'aramide inclut au moins 25 pour cent en poids de floc de para-aramide par rapport au poids total du floc d'aramide seulement.

2. Feuille non tissée par voie humide selon la revendication 1, dans laquelle le floc d'aramide inclut 100 pour cent en poids de floc de para-aramide par rapport au poids total du floc d'aramide seulement.

3. Feuille non tissée par voie humide selon la revendication 1 ou la revendication 2, dans laquelle le floc d'aramide a une longueur moyenne de 3 à 13 millimètres.

4. Feuille non tissée par voie humide selon la revendication 1, dans laquelle le floc d'aramide comprend un floc de para-aramide et un floc de méta-aramide.

5. Préimprégné qui inclut la feuille non tissée par voie humide selon l'une quelconque des revendications 1 à 4.

6. Stratifié préparé à partir du préimprégné de la revendication 5.

7. Carte de circuits imprimés qui inclut le stratifié de la revendication 6.

8. Procédé pour fabriquer une feuille de floc d'aramide, dans lequel le floc d'aramide inclut au moins 25 pour cent en poids de floc de para-aramide par rapport au poids total du floc d'aramide seulement, et dans lequel la feuille comprend moins de 2 pour cent en poids de liant par rapport au poids total du liant et du floc, comprenant les étapes consistant:
a) à préparer une dispersion aqueuse de 0,005 à 0,08 pour cent en poids de floc d'aramide qui inclut au moins 25 pour cent en poids de floc de para-aramide par rapport au poids du floc seulement, et moins de 2 pour cent en poids de liant par rapport au poids total du liant et du floc;
b) à verser la dispersion sur un quadrillage mobile dans une machine à fabriquer le papier;
c) à soutirer l'eau à partir de la dispersion aqueuse pour laisser un feutre de papier mouillé; et
d) à sécher le feutre de papier mouillé sur l'écran support pour fabriquer une feuille de floc d'aramide essentiellement exempt de liant.

9. Procédé selon la revendication 8, dans lequel le floc d'aramide a une longueur moyenne de 3 à 13 millimètres.

10. Procédé selon la revendication 8 ou la revendication 9, comprenant en outre l'étape consistant à hydroenchevêtrer la feuille non tissée ayant ou après le séchage de la feuille non tissée.

11. Procédé selon l'une quelconque des revendications 8 à 10, comprenant en outre l'étape consistant à calandrer à chaud la feuille séchée de floc d'aramide essentiellement exempt de liant.
